# FASCICULE DE BREVET EUROPEEN

(11) **EP 3 956 494 B1**
(45) Date de publication et mention de la délivrance du brevet: **22.03.2023**
(21) Numéro de dépôt: 20721779.5
(22) Date de dépôt: 20.04.2020
(51) Int. Cl.: C23C 14/58, C23C 16/56, C23C 4/18, C25D 5/48, C23C 24/04

(54) **PROMOTION DE L'ADHÉRENCE DE COUCHES MINCES**
FÖRDERUNG DER ADHÄSION VON DÜNNSCHICHTEN
PROMOTING ADHESION OF THIN FILMS

(30) Priorité: 18.04.2019 CH 5342019
(43) Date de publication de la demande: 23.02.2022
(73) Titulaire: Sy&Se SA, 2300 La Chaux-de-Fonds (CH)
(72) Inventeur: TELMONT, Florian, 2034 Peseux (CH); BRUN, Sébastien, 2057 Villiers (CH); AELLEN, Thierry, 2000 Neuchâtel (CH); FARINE, Sophie, 2405 La Chaux-du-Milieu (CH); KEPPNER, Herbert, 2013 Colombier (CH)
(74) Mandataire: P&TS SA (AG, Ltd.)
(86) Numéro de dépôt international: PCT/IB2020/053704
(87) Numéro de publication internationale: WO 2020/212957

(56) Documents cités:
- WO-A1-2017/006218
- WO-A1-2017/006219
- WO-A2-2015/104252
- US-A1- 2011 050 043

## Description

### Domaine technique

La présente invention se rapporte à un procédé de la promotion d'adhérence d'une couche mince sur un substrat. Notamment, mais pas exclusivement, la présente invention concerne un procédé de promotion de l'adhérence entre un substrat métallique, mais pas exclusivement et une couche mince, par exemple une couche PVD, galvanique, ou d'une nature différente, avec l'application d'un champ électrique.

La spécificité et le but de la présente invention sont de produire une diffusion d'espèces chimiques à l'interface entre le substrat et la couche mince amenant une meilleure adhérence, une restructuration de la couche ainsi que la création d'un matériau composite à l'interface.

Parmi ses multiples applications industrielles, le présent procédé permet l'adhérence de couches minces dans des dispositifs médicaux, sur des outils de coupe, dans la production de modules photovoltaïques, d'écrans d'affichage, de semiconducteurs, améliore la qualité des revêtements antireflets appliqués sur les vitres de fenêtre, sur des verres de lunettes, ou sur des éléments d'optique, et augmente la résistance des couches décoratives appliquées sur une multitude d'objets.

### Etat de la technique

En général, les éléments assemblés afin de composer les objets qui nous entourent que ce soit dans les objets usuels ou les systèmes hautement technologiques dans les domaines tels que la mécanique, l'électronique, l'optique ou les dispositifs de contrôle ou d'analyses sont pourvus d'un revêtement.

La fonctionnalité du revêtement, qui confère les caractéristiques essentielles au fonctionnement ou simplement adaptée aux exigences d'un besoin particulier, est fortement lié à ses propriétés d'adhésion. Afin de garantir l'adhésion d'un revêtement, on peut effectuer une préparation de surface à l'aide d'un plasma ou d'une solution chimique avant que le revêtement ne soit déposé ou mécanique. Il existe également des traitements une fois le revêtement déposé, les procédés de cuissons par exemple, pour augmenter la diffusion des deux matériaux à l'interface et permettre une meilleure liaison entre le revêtement et l'objet.

La température durant la déposition du revêtement influence également les propriétés du revêtement et son adhésion, c'est pour cette raison par exemple que l'on privilégie la technologie CVD à haute température pour la déposition des revêtements des optiques pour les lasers à grande énergie ou des composants mécaniques fortement sollicités dans l'industrie automobile par rapport au procédé PVD.

De plus, l'adhésion et la création d'un matériau composite à l'interface a pour effet une augmentation de la fiabilité et du vieillissement du système.

En termes de substrat, l'industrie se tourne aujourd'hui sur des matériaux plus légers que les traditionnels aciers, i.e. les aciers à haute limite élastique (HLE), à très haute limite élastique (THLE), et les métaux et alliages comme l'aluminium, le magnésium ou le titane. Parallèlement, le développement de composites à matrice organique pour alléger les dispositifs actuels (déjà le cas pour l'industrie automobile). On a également recours à la déposition de revêtement métallique sur des substrats légers par projection dynamique (cold-spray) afin de faciliter la méthode de déposition tout en obtenant des caractéristiques proches de métaux à grande densité.

Le procédé d'assemblage anodique (anodic bonding) est utilisé dans le domaine général de la microtechnique, plus particulièrement dans les secteurs biomédicaux, aérospatiaux et en électronique. Dans ces domaines, notamment en microélectronique et les domaines voisins, les assemblages anodiques sont surtout utilisés pour les films et couches minces et plates notamment comme des lames de métal, de verre et de silicium. Le procédé nécessitant de températures relativement élevées, il est on général utilisé pour assembler des matériaux avec des coefficients de dilatation thermique proches, afin de limiter les contraintes liées aux différences de contraction.

Dans la technique connue, l'assemblage anodique est principalement réservé au jointage du verre, notamment du verre Pyrex^{®} ou borofloat^{®} (verre au borosilicate).

Par le même principe de limitation des contraintes, des assemblages anodiques de petite taille et de faible masse ou des éléments non soumis à des forces mécaniques externes, ont été décrits dans le secteur horloger dans le document JP08166469A, pour fixer une plaque de verre sur un cadran métallique ou en silicium. Le brevet JP05080163A décrit également la fixation d'index en silicium apposés sur une plaque en verre du cadran par l'assemblage anodique. Les procédés connus ne permettent toutefois pas l'assemblage de composantes massives, soumises à des contraintes mécaniques élevées, et devant résister aux chocs, notamment lorsque les pièces à joindre sont réalisées avec des matériaux hétérogènes, avec des coefficients de dilatation dissimilaires, comme c'est le cas pour l'acier inoxydable et le saphir utilisé pour réaliser les glaces de montre.

WO2017006219 décrit un procédé d'assemblage anodique à basse température impliquant un champ électrique avec une composante pulsée ou alternée. WO2015104252 et WO2017006218 décrivent des procédés d'assemblage anodique similaires utilisés dans l'industrie horlogère.

Dans la technique connue, on connaît aussi un grand nombre de procédés de déposition de couches minces pour plusieurs fonctions, par exemple des couches anti-usure sur des outils de coupe, des couches décoratives donnant une couleur attrayante à une surface, des couches antireflets, conductrices, hydrophiles, hydrophobes, oléophobes, photovoltaïques, semiconductrices et bien d'autres. Les couches minces peuvent être déposées par une variété de procédés inclus des procédés de déposition physique en phase vapeur (PVD) des procédés chimiques en phases vapeur (CVD), des procédés sol-gel, des méthodes galvaniques, par enduction centrifuge, électrospinning, des dépositions par torche plasma, et autres.

On connaît également plusieurs procédés visant à améliorer l'adhérence entre le substrat et la couche déposée, par exemple par l'interposition de couches intermédiaires, dites d'accrochage, ou par une préparation et par un nettoyage soigné des surfaces. Malgré cela, le délaminage de la couche du substrat ne peut pas toujours être évité.

### Bref résumé de l'invention

Un but de la présente invention est de proposer un procédé pour améliorer l'adhérence d'une couche mince sur un substrat par rapport aux couches minces connues. Avantageusement, le procédé se déroule à basse température, bien inférieure aux températures de transition ou de fusion des matériaux employés.

Selon l'invention, ces buts sont atteints notamment au moyen de l'objet de la revendication 1.

### Brève description des figures

Des exemples de mise en oeuvre de l'invention sont indiqués dans la description illustrée par les figures annexées dans lesquelles :
- La figure 1 illustre schématiquement un dispositif d'assemblage permettant de mettre en oeuvre le procédé de l'invention.
- La figure 2 illustre des étapes du procédé inventif.

### Exemple(s) de mode de réalisation de l'invention

Dans un mode de réalisation qui sera décrit en détail par la suite, le procédé de l'invention est appliqué à l'adhérence d'une couche mince 23 sur un substrat 20. La couche 23 pourrait être par exemple une couche anti-usure en TiN sur un outil de coupe, ou une couche colorée, ou une couche de biocéramique, soit une céramique ayant une composition similaire à celle d'un tissu organique, sur un implant dentaire, ou toute autre couche fonctionnelle ou décorative.

La couche 23 peut être appliquée par tout procédé chimique ou physique, par exemple par déposition physique en phase vapeur (PVD), déposition chimique en phase vapeur (CVD), déposition chimique en phase vapeur assistée par plasma (PE-CVD), croissance par couches atomiques (ALD), torche plasma, électrospinning, spraying, divers procédés galvaniques, les procédés sol-gel, et bien d'autres. La couche 23 peut être isolante, semi-conductrice, ou conductrice, cristalline (mono-, poly- ou, pour les polymères, semi-cristalline pour les polymères), ou amorphe.

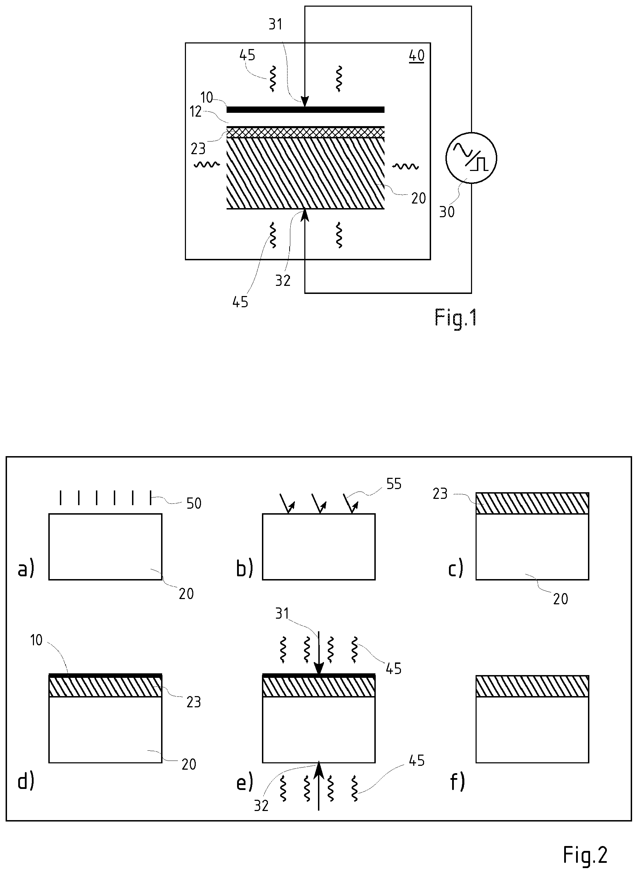

L'invention peut être appliquée à l'assemblage d'une variété d'objets ou composants. La description sera mieux comprise avec référence à la figure 1 qui représente, en section, un dispositif d'assemblage anodique.

La pièce 20 est destinée à recevoir la couche fonctionnelle ou décorative 23. Le substrat 20 peut être fabriqué avec tous les matériaux utilisés normalement. On peut citer, par exemple :
a) acier inoxydable,
b) or, ou alliages à base d'or,
c) platine,
d) titane,
e) aluminium,
f) céramique,
g) verre,
h) polymère,
i) matériaux composites

### cette liste n'est pas exhaustive.

La pièce 20 peut être réalisée par n'importe quel procédé connu, par exemple par usinage, étampage, impression 3D, ou tout autre procédé. Il n'est pas important que la face destinée à recevoir la couche 23 soit parfaitement plane, car la couche est déposée par un procédé qui lui permet d'épouser parfaitement la forme du substrat en contact intime.

On a constaté que le procédé de l'invention ne requiert pas une composition chimique homogène de la couche 23. Bien on contraire, des couches présentant un gradient chimique et/ou d'oxydation ont fourni des résultats supérieurs en termes d'adhérence, solidité de la liaison et rapidité d'assemblage. Dans un cas typique impliquant une couche de titane, la couche 23 présente une épaisseur allant de 1 nm à 10 µm et sa composition varie du titane pur, dans les régions plus profondes, à l'oxyde TiOz en surface, en passant par toutes les stoechiométries intermédiaires. Comme on le verra par la suite, ce gradient chimique peut être accentué avec des expositions à un plasma réactif.

Plusieurs matériaux se prêtent à la déposition de la couche 23. Des couches de titane, comme mentionné plus haut, ont donné des excellents résultats, mais l'invention peut être répliquée avec d'autres matériaux, par exemple Zr, Hf, Fe, Si, Al, parmi d'autres. Le gradient chimique peut être obtenu par oxydation, nitruration, carburation, par exemple, dans lequel cas la composition de la couche peut être de type TiₓO_{y}, SiₓO_{y}, SiₓN_{y}, AlₓO_{y}, ou ZnₓO_{y}. La couche 23 peut être enrichie par des atomes/ions mobiles tels que Li, Na, K, Ca, Be, ou halogènes. On peut faire adhérer sur le substrat 20 des couches de biocéramique, par exemple d'hydroxyapatite, principale composante minérale de l'émail dentaire, de la dentine, et de l'os.

L'invention n'est pas non plus limitée à des substrats métalliques ou conducteurs, mais elle a été appliquée avec succès aussi à des éléments semiconducteurs, tels que des éléments de panneaux photovoltaïques, ou à des substrats isolants comme le verre ou le corindon. On peut par exemple faire adhérer sur un élément transparent des couches antireflets, polarisantes, ou des couches conductrices transparentes, par exemple des électrodes de ITO sur un écran tactile ou sur un écran LCD.

La Figure 1a représente très schématiquement un dispositif d'assemblage permettant de réaliser le procédé inventif. Le substrat 20 porte une couche 23 sur une face, et l'électrode 10 est positionnée sur la couche 23 dans une enceinte 40. Des moyens de chauffage 45 permettent de maintenir les pièces à une température voulue. Caractéristiquement, l'invention se déroule à des températures inférieures à celles des procédés d'assemblage anodique conventionnels. La température est préférablement inférieure à 250 °C. Des résultats très satisfaisants ont été obtenus à des températures de 200 °C, 150 °C, 100 °C, et même de 75 °C. En aucun cas la température ne sera proche de celle de fusion ou de transition vitreuse des matériaux employés.

L'électrode 10 est reliée à un circuit 31 et le substrat est connecté à une contre électrode 32, entre lesquelles on branche une source de tension 30. La source de tension produit un champ électrique qui engendre une migration d'ions entre les éléments 20, 23, 10.

La tension générée par la source 30 comporte une composante continue (sa valeur moyenne) dans les limites de ce qui est généralement employé dans les procédés d'assemblage anodique, soit dans l'intervalle 0.1-50 kV ou plus, selon l'épaisseur des pièces à joindre et la rigidité diélectrique de l'assemblage. On a constaté que la qualité de l'adhérence s'améliore considérablement lorsqu'une composante AC ou pulsée est superposée à la composante continue. L'amplitude de la composante AC ou la hauteur des impulsions sera comparable à celle de la composante continue, et la fréquence caractéristique sera supérieure à 100 Hz, par exemple de 1 kHz, 10 kHz, ou plus. Caractéristiquement, la fréquence de la composante AC ou des impulsions sera supérieure aux fréquences de relaxation diélectrique des matériaux utilisés.

Si requis, les pièces 20, 10 peuvent être compressés mécaniquement. On a toutefois constaté qu'un tel plaquage est souvent superflu. Les vitesses d'assemblage sont de l'ordre de quelques minutes.

Entre la couche 23 et le substrat 20 on peut déposer des couches minces avec une fonction esthétique ou antireflet (si le substrat 20 est transparent, par exemple), ou pour améliorer l'adhérence, ou pour tout autre but. Ces couches supplémentaires ne sont pas représentées sur les figures. La transition entre les matériaux des couches peut être discontinue ou graduelle.

Toute particule chargée placée sous l'influence d'un champ électrique uniforme se déplace à une vitesse proportionnelle à ce champ, le facteur de proportionnalité étant appelé la mobilité électrique de la particule. Cette migration va s'effectuer de l'anode vers la cathode pour les particules chargées positivement, dans le sens opposé pour les particules chargées négativement. Sous l'effet de la migration des ions, on observe une différence de potentiel entre les partenaires, ce qui engendre un plaquage entre les partenaires par attraction électrostatique. La perturbation de l'équilibre thermodynamique influence les populations de porteurs de charge localisés au sein des pièces à assembler et de la couche intermédiaire. Les origines des perturbations peuvent être :
- les inhomogénéités de dopage, d'impuretés, de défauts structuraux et les déformations locales (principalement au voisinage de surface), des contacts et des jonctions
- les forces de champ électrique
- les gradients de température.

Lorsque le champ électrique ainsi que la température sont interrompus, les porteurs de charges tendent vers un état d'équilibre correspondant à des régimes permanents définis par des conditions initiales et aux bords, selon des mécanismes typiques :
- la diffusion des porteurs dans des gradients de concentration
- le déplacement des porteurs dans des champs électriques internes
- la génération et la recombinaison de porteurs qui peuvent être intrinsèques ou faire intervenir des centres de recombinaison et des pièges.

Les propriétés relatives aux courants électriques et aux déplacements de porteurs de charge sous l'influence de forces appliquées sont appelées phénomènes de transport. Parmi les phénomènes de transport, la mobilité, qu'elle soit par exemple des lacunes, des impuretés, des porteurs de charges (les matériaux sont différenciés par la longueur de Debye des porteurs majoritaires et leur comportement est notamment décrit par l'équation de continuité) ainsi que la diffusion (basée sur les lois de Fick) sont les mécanismes clés d'assemblage anodique.

Les paramètres qui influencent le plus la mobilité des porteurs de charge sont la température, la nature du réseau et le nombre volumique d'impuretés. Parmi les défauts on peut distinguer les impuretés et les lacunes. Il s'agit de ces mêmes lacunes, défauts de Schottky ou de Frenkel entre autres qui facilitent la diffusion des porteurs de charges et qui définissent l'énergie nécessaire à leur diffusion. De plus déplacer une lacune à travers un cristal demande beaucoup moins de travail que de contraindre un ion à se déplacer à travers un réseau d'ion dense d'un cristal. La conduction ionique dépend du mouvement des lacunes. Les impuretés qui contribuent à la densité de porteurs de charge sont appelées "donneurs" si elles apportent des électrons supplémentaires et "accepteurs" si elles apportent des trous supplémentaires. A noter que la vitesse du phénomène de l'assemblage anodique dépend de la quantité de défauts et de la température notamment.

Le choix de la ou des couches intermédiaires dépend fortement des "propriétés" des porteurs de charge. La composition chimique de la ou des couches est naturellement importante puisque les phénomènes de transport dépendent des caractéristiques des liaisons atomiques. Les liaisons créées lors du processus d'assemblage anodique sont des liaisons de type covalentes majoritairement. Ces liaisons fortes s'établissent par la mise en commun d'une paire d'électrons issus de chacun des porteurs de charges.

D'autres paramètres ont leurs importances telles que l'épaisseur des pièces à assembler ainsi que l'épaisseur de la zone de déplétion.

La figure 2 représente schématiquement une succession d'étape du procédé inventif. La pièce 20, accessoirement usinée et/ou polie et d'abord nettoyée (étape a) par des bains de lessivages, ou par ultrason, ou par tout procédé de lavage 50 approprié. Ensuite (étape b) on crée une couche fonctionnelle ou décorative par déposition PVD 55, comme on a discuté plus haut, ou par tout autre procédé idoine. L'étape c) représente l'élément 20 avec la couche intermédiaire 23 activée.

La surface ou les surfaces à joindre sont préférablement activées par un bombardement de plasma réactif (non représenté). Les caractéristiques chimiques et physiques du plasma seront choisies en fonction de la chimie souhaitée pour la couche intermédiaire. Des plasmas d'oxygène appliqués à des couches de titane ou d'acier ont donné des assemblages très satisfaisants en termes de solidité et rapidité. L'activation a lieu si possible, dans le même réacteur dans lequel on réalise la déposition 55.

Les surfaces activées sont sensibles à l'air, pour cette raison il est préférable de compléter l'assemblage rapidement après l'étape d). Les éléments 23 et 20 sont mis en contact et chauffés (étape e), puis le champ électrique est appliqué par les électrodes10, 31, 32 (étape f) pour un temps déterminé, jusqu'à l'obtention du lien anodique. L'électrode 10 est enfin retirée.

Dans une variante de l'invention, l'électrode 10 est une lame d'un matériau isolant, par exemple une électrode en céramique, verre, ou en un matériau cristallin, optionnellement avec une couche conductrice équipotentielle au dos.

On peut exécuter le procédé de l'invention avec l'électrode 10 en contact avec la couche 23, éventuellement avec une force d'appui plus ou moins importante. Un tel placage n'est cependant pas essentiel ; on a obtenu de bons résultats (amélioration considérable de l'adhérence entre substrat 20 et couche mince 23) même lorsque l'électrode 10 et la couche 23 restent séparées par un espace vide 12 pendant l'application du champ électrique. L'espace vide 12 peut aller de 0 à 20 mm ou plus.

### Exemple

Les effets bénéfiques du procédé de l'invention ont été vérifiés sur un échantillon composé d'une lame métallique (par exemple en acier) sur laquelle on a déposé une couche de Ti/TiN par PVD. On compare l'adhérence de la couche entre deux échantillons identiques, un duquel a subi le procédé d'amélioration d'adhérence par courant pulsé de l'invention. Les échantillons sont pliés sur un angle de 170° pour mettre en tension la couche mince.

Nous observons sur l'échantillon de contrôle :
- Une déchirure axiale de la couche selon la courbure de notre pièce.
- Des « éclatements » de la couche en certains points où la traction est la plus importante, notamment au niveau des arêtes de la pièce.

Nous observons sur l'échantillon traité selon l'invention :
- Une structure identique avant courbure sans modification apparente après le test de courbure.
- Aucun éclatement de la couche.

### Numéros de référence employés sur les figures

- 10: électrode
- 12: espace
- 20: substrat
- 23: couche fonctionnelle ou décorative
- 30: source de tension
- 31: électrode
- 32: contre-électrode
- 40: enceinte
- 45: énergie thermique et/ou électromagnétique
- 50: lavage
- 55: déposition
- 65: activation de surface

## Revendications

1. Procédé d'amélioration de l'adhérence d'une couche sur un substrat comprenant :
déposition d'une couche fonctionnelle ou décorative sur le substrat;
application d'une électrode au-dessus de la couche;
chauffage à une température d'adhérence déterminée;
application d'une tension électrique entre le substrat et l'électrode;
retrait de l'électrode.

2. Procédé selon la revendication précédente, dans lequel une interface entre le substrat et la couche présente un gradient chimique et/ou un gradient d'oxydation.

3. Procédé selon l'une des revendications précédentes, dans lequel ladite tension électrique comporte une composante pulsée ou AC et une composante DC.

4. Procédé selon l'une des revendications précédentes, dans lequel ladite température d'adhérence est inférieure à 300 °C, préférablement inférieure à 200 °C.

5. Procédé selon la revendication précédente, dans lequel ladite composante pulsée ou AC a une fréquence supérieure à 50 Hz, préférablement supérieure à 100 Hz.

6. Procédé selon l'une des revendications précédentes, dans lequel ledit substrat est métallique, par exemple un substrat en acier, acier inoxydable, titane, platine ou céramique, par exemple corindon, zircone et la couche mince est une couche de type PVD, ALD, sol-gel, ou galvanique.

7. Procédé selon l'une des revendications précédentes, comprenant une étape de fonctionnalisation par un plasma réactif, par exemple un plasma d'oxygène.

8. Procédé selon l'une des revendications précédentes, dans lequel la couche est:
une couche de biocéramique, par exemple une couche d'hydroxyapatite, sur un dispositif implantable; ou
une couche anti-usure, par exemple une couche de TiN ou DLC, sur un outil de coupe ; ou
une couche antireflet sur une vitre, un verre optique, ou un élément optique ; ou
un élément d'un dispositif photovoltaïque ; ou
un élément d'un dispositif d'affichage.

## Patentansprüche

1. Verfahren zur Steigerung der Haftung einer Schicht auf einem Substrat, umfassend:
Aufbringen einer funktionalen oder dekorativen Schicht auf das Substrat;
Anlegen einer Elektrode oberhalb der Schicht;
Erhitzen auf eine bestimmte Adhäsionstemperatur;
Anlegen einer elektrischen Spannung zwischen dem Substrat und der Elektrode;
Entfernen der Elektrode.

2. Verfahren nach dem vorstehenden Anspruch, bei dem eine Grenzfläche zwischen dem Substrat und der Schicht einen chemischen Gradienten und/oder einen Oxidationsgradienten aufweist.

3. Verfahren nach einem der vorstehenden Ansprüche, wobei die elektrische Spannung eine Puls- oder Wechselstromkomponente und eine Gleichstromkomponente aufweist.

4. Verfahren nach einem der vorstehenden Ansprüche, wobei die Adhäsionstemperatur unter 300°C, vorzugsweise unter 200°C, liegt.

5. Verfahren nach dem vorstehenden Anspruch, bei dem die Puls- oder Wechselstromkomponente eine Frequenz über 50 Hz, vorzugsweise über 100 Hz, aufweist.

6. Verfahren nach einem der vorstehenden Ansprüche, wobei das Substrat metallisch, beispielsweise ein Substrat aus Stahl, Edelstahl, Titan, Platin oder keramisch wie beispielsweise Korund, Zirkoniumdioxid ist, und die dünne Schicht eine Schicht vom Typ PVD, ALD, Sol-Gel oder galvanisch ist.

7. Verfahren nach einem der vorstehenden Ansprüche, umfassend einen Schritt des Funktionalisierens durch ein reaktives Plasma, z. B. ein Sauerstoffplasma.

8. Verfahren nach einem der vorstehenden Ansprüche, wobei die Schicht:
eine Schicht aus Biokeramik, beispielsweise eine Schicht aus Hydroxylapatit, auf einer implantierbaren Vorrichtung; oder
eine verschleißfeste Schicht, beispielsweise eine TiN- oder DLC-Schicht, auf einem Schneidwerkzeug; oder
eine Antireflexionsschicht auf einer Glasscheibe, einem optischen Glas oder einem optischen Element; oder
ein Element einer photovoltaischen Vorrichtung; oder
ein Element einer Anzeigevorrichtung ist.

## Claims

1. Method of improving the adhesion of a layer on a substrate comprising:
deposing of a functional or decorative layer on the substrate;
applying an electrode above the layer;
heating to a determined adhesion temperature;
applying an electric potential between the substrate and the electrode;
removing the electrode.

2. Method according to the preceding claim, wherein an interface between the substrate and the layer exhibits a chemical gradient and/or an oxidation gradient.

3. Method according to any one of the preceding claims, wherein said electric potential has a pulsed or AC component and a DC component.

4. Method according to any one of the preceding claims, wherein said adhesion temperature is less than 300 °C, preferably less than 200 °C.

5. Method according to the preceding claim, wherein said pulsed or AC component has a frequency above 50 Hz, preferably above 100 Hz.

6. Method according to any one of the preceding claims, wherein said substrate is metallic, for example a substrate of steel, stainless steel, titanium, platinum, or said substrate is ceramic, for example corundum, zircon, and the thin layer is a layer PVD, ALD, sol-gel, or galvanic-deposed.

7. Method according to any one of the preceding claims, including a reactive plasma functionalization step, for example by an oxygen plasma.

8. Method according to any one of the preceding claims, wherein the layer is:
a bio ceramic layer, for example a layer of hydroxyapatite, on an implantable device; or
an anti-wear layer, for example a layer of TiN or DLC, on a cutting tool; or
an antireflection layer on a windowpane, an optical glass, or an optical element; or
an element of a photovoltaic device; or
an element of a display device.
